# EUROPEAN PATENT APPLICATION

(11) **EP 2 674 974 A1**
(43) Date of publication of application: **18.12.2013**
(21) Application number: 12008551.9
(22) Date of filing: 21.12.2012
(51) Int. Cl.: H01L 23/58, H01L 23/532

(54) **Semiconductor structure with improved noise isolation between a seal ring and active circuits**

(30) Priority: 11.06.2012 US 201213493079
(71) Applicant: Broadcom Corporation, Irvine, CA 92617 (US)
(72) Inventor: Ranganathan, Sumant, Saratoga, CA 95070 (US); Oertle, Kent, Phoenix, AZ 85076 (US); Wan, Yew, Fremont, CA 94539 (US)
(74) Representative: Jehle, Volker Armin

(57) **Abstract**

A semiconductor structure includes a substrate layer (202) and a conductive layer (204) connected with the substrate layer. An active circuit (110) is connected with the conductive layer. A seal ring (102) is connected with the conductive layer and separated from the active circuit by an assembly isolation region (104). An electrical isolation region (320) is positioned in the conductive layer and adjacent to the assembly isolation region, where the electrical isolation region extends to the substrate layer.

## Description

### 1. Technical Field

This disclosure relates to semiconductors. In particular, this disclosure relates to layouts of semiconductor die that improve electrical isolation between seal rings and active circuits.

### 2. Background

Integrated circuits are often implemented using semiconductors. Semiconductor integrated circuit designs can be mixed-signal active circuit designs that include both analog and digital circuits. In addition to the analog and digital circuits, a seal ring may surround the active circuit to provide mechanical support for the semiconductor and to protect against harmful environmental effects.

### BRIEF DESCRIPTION OF THE DRAWINGS

The innovation may be better understood with reference to the following drawings and description. In the figures, like reference numerals designate corresponding parts throughout the different views.

Figure 1 shows an example of a top view of semiconductor die.

Figure 2 is an example of a cross-section of a semiconductor die.

Figure 3 is another example of a cross-section of a semiconductor die.

Figure 4 is another example of a cross-section of a semiconductor die.

### DETAILED DESCRIPTION

The discussion below makes reference to semiconductor die. Semiconductor die are typically integrated circuits that are formed in large batches on a semiconductor wafer. Integrated circuits are then cut away from the wafer as a semiconductor die. The semiconductor die may be a layered structure, where the layers provide specific electrical and physical properties to form integrated circuits with desired functionality. The integrated circuits formed on a semiconductor material may be active circuits including analog circuits or digital circuits or both. The various layers of the semiconductor die may include a substrate. In addition, the semiconductor die may include a conducting layer. The conducting layer with the substrate may have electrical and physical properties that may be beneficial for forming a circuit with the desired functionality. As the volume of circuitry increases as the die area shrinks, improved layouts may provide sufficient isolation between analog and digital circuitry. In semiconductors with a seal ring, improved layouts can be used to prevent the seal ring from allowing noise to couple between analog and digital circuitry.
According to one aspect of the invention, a semiconductor structure is provided that comprises:
a substrate layer;
a conductive layer connected with the substrate layer;
an active circuit connected with the conductive layer;
a seal ring connected with the conductive layer and separated from the active circuit by an assembly isolation region; and
an electrical isolation region positioned in the conductive layer and adjacent to the assembly isolation region, where the electrical isolation region extends to the substrate layer.
Advantageously, the active circuit comprises a noise sensitive circuit and a noisy circuit.
Advantageously, the noise sensitive circuit and the noisy circuit comprise a least one of an analog circuit and a digital circuit.
Advantageously, the structure further includes an active isolation region to electrically isolate the analog circuit from the digital circuit.
Advantageously, the conductive layer comprises a p-well.
Advantageously, the electrical isolation region comprises a shallow trench isolation layer; and a native layer connected with the shallow trench isolation layer and the substrate layer.
Advantageously, the native layer comprises a native oxide which is native to the substrate layer.
Advantageously, the electrical isolation region comprises a shallow trench isolation layer and a well layer connected with the shallow trench isolation layer, where the well layer extends into the substrate.
Advantageously, the well layer comprises an n-well.
Advantageously, the structure further comprises a well layer and a deep well layer connected with the well layer, where the deep well layer extends into the substrate layer.
Advantageously, the well layer comprises an n-well and the deep well comprises a deep n-well.
According to another aspect of the invention, a semiconductor structure comprises:
a conductive layer; and
an electrical isolation region positioned in the conductive layer, the electrical isolation region electrically disconnecting the conductive layer between an active circuit and a seal ring.
Advantageously, the electrical isolation region comprises an oxide.
Advantageously, the electrical isolation region comprises a well.
Advantageously, the well comprises an n-well.
Advantageously, the electrical isolation region comprises a well and a deep well.
According to another aspect of the invention, a die is provided that comprises:
a substrate layer;
a conductive layer connected with the substrate layer, the conductive layer including an electrical isolation region;
a seal ring connected with the conductive layer; and
an active circuit connected with the conductive layer, the active circuit electrically separated from the seal ring by the electrical isolation region, where the electrical isolation region connects with the substrate.
Advantageously, the active circuit comprises a noise sensitive circuit and a noisy circuit.
Advantageously, the electrical isolation region comprises a native oxide.
Advantageously, the electrical isolation region comprises a well.

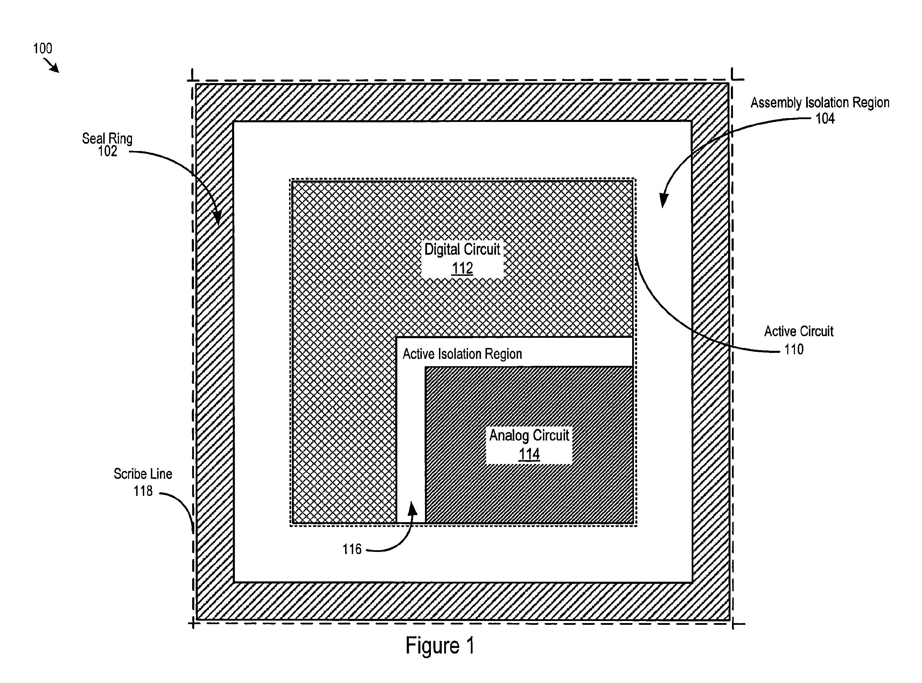

Figure 1 shows an example of a semiconductor die when viewed from above, showing the various regions of the semiconductor. The semiconductor die may include an active circuit 100 and a seal ring 102. The seal ring 102 may surround the active circuit 110 to serve as a barrier to environmental penetrants such as moisture, chemicals, or corrosive gases. The seal ring 102 also serves as a mechanical barrier that helps prevent cracks from propagating into the active circuit 100 during the die saw operation. The seal ring 102 may be made of alternating conducting layers and insulating layers. Vias may connect the conducting layers to one another, and the seal ring may be connected to the substrate.

In addition the active circuit 110 may be connected to the substrate and may include a digital circuit 112 and an analog circuit 114. In some examples, a semiconductor die may include regions of active circuitry, where one region of active circuitry is isolated from another region of active circuitry. Isolating regions of active circuitry includes that the circuits may not share a common electrical ground and may be electrically separated from one another by a high impedance. Isolation may be desirable when, for example, the active circuit is a mixed-signal circuit having analog circuitry and digital circuitry. Circuit designers may design such a mixed-signal circuit to provide adequate electrical isolation between digital circuitry and analog circuitry. It may be important to isolate the analog circuitry from the digital circuitry because, as one example, the analog circuitry may be noise sensitive circuitry that is sensitive to spurious emissions, noise, or other extraneous signals. For example, the digital circuitry may be noisy circuitry containing clock signals and other noise that may adversely affect the analog circuitry. To prevent the digital circuitry from adversely affecting the analog circuitry, the digital circuitry may be isolated from the analog circuitry.

Therefore, referring to Figure 1, the digital circuit 112 may be electrically isolated from the analog circuit 114 by an active isolation region 116. The active isolation region 116 helps prevent coupling of signals, noise, and other interference from the digital circuit 112 to the analog circuit 114, and vice versa. Isolating the digital circuit 112 from the analog circuit 114 may include electrically isolating the digital region 112 from the analog region 114. Electrically isolating includes the digital circuit 112 not sharing an electrical ground with the analog circuit 114. In order to electrically isolate analog circuits from digital circuits, the active isolation region 116 may include a native layer, an oxide such as silicon dioxide, or other material for blocking the p+ p-well implant in the active isolation region 116 to help electrically isolate the digital circuit 112 from the analog circuit 114.

Surrounding the periphery of the active circuit 110 is an assembly isolation region 104. This may be a physical gap that separates the periphery of the active circuit 110 from the seal ring 102. The physical gap between the active circuit 110 and the seal ring may help prevent physically or electrically connecting the seal ring 102 with the active circuit 110. As one example, the width of the assembly isolation region 104 may be approximately 6 to 10 microns.

A seal ring 102 may surround the periphery of the assembly isolation region 104. The seal ring 102 may provide mechanical support and serve as a barrier to environmental penetrants, such as moisture, chemicals, or corrosive gases, from reaching the active circuit 110. The outermost periphery of the seal ring 102 may be a scribe line 118 where the individual semiconductor die is cut away from the semiconductor wafer. The seal ring 102 may serve as a mechanical barrier that helps prevent cracks from propagating into the active circuit 100 during the die cut operation.

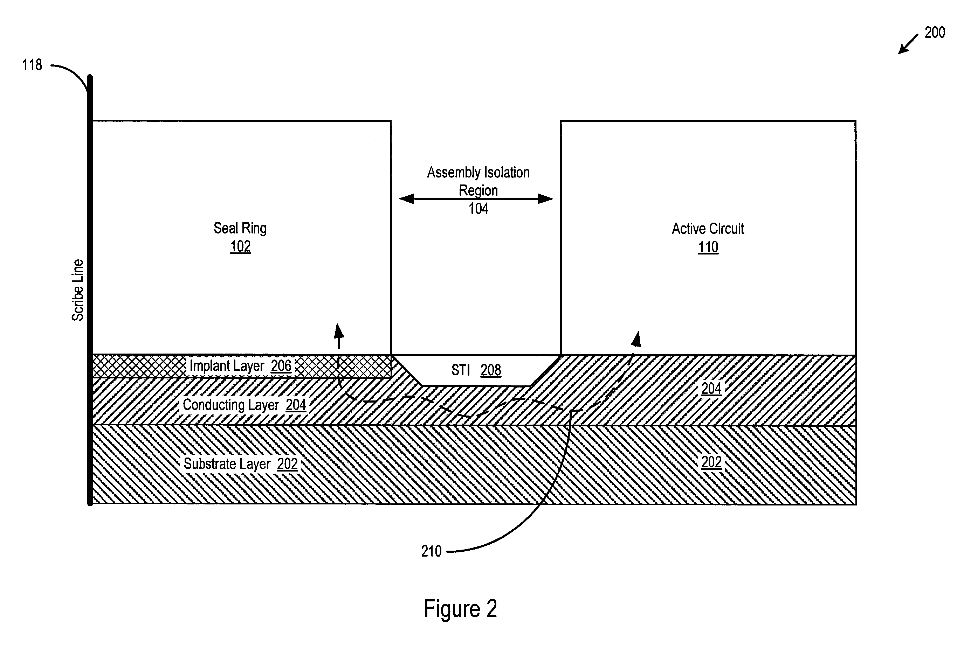

Figure 2 shows an example of a semiconductor die when viewed as a cross-section 200. In addition to the active circuit 100, the semiconductor die may include a seal ring 102. The seal ring 102 may be made of alternating conducting layers and insulating layers. Vias may connect the conducting layers to one another, and the seal ring may be connected to a substrate layer 202. Alternatively, the seal ring 102 may connect to the substrate layer 202 through an implant layer 206 or through an implant layer 206 and a conducting layer 204. For example, the implant layer 206 may be a p+ implant layer. Depending on the types of properties desired for the semiconductor die, the substrate layer 202 and conducting layer 204 may have various conductivity types. For example, the substrate layer 202 may include a p-type substrate while the conducting layer 204 may include an n-well conducting layer. In another embodiment, the substrate layer 202 may include an n-type substrate while the conducting layer 204 may include a p-well conducting layer.

The seal ring 102 and active circuit 110 can be physically separated by an assembly isolation region 104 that may form an air gap between seal ring 102 and active circuit 110. Additionally, to reduce current leakage between active circuit 110 and seal ring 102, a shallow trench isolation (STI) region 208 may be placed in the substrate below the assembly isolation region 104. The STI region 208 may provide a high impedance path and may reduce coupling between seal ring 102 and active circuit 110 through STI region 208. However, even with STI region 208, it is possible that seal ring 102 and active circuit 110 may be electrically connected, as shown by coupling path 210, through conducting layer 204. When seal ring 102 and active circuit 110 are electrically connected, it is possible for signals, noise, and other interference from digital circuit 112 (Fig. 1) to couple, through the coupling path 210, to the analog circuit 114 (Fig. 1). As described above, such coupling may be undesirable, for example when it is desired that the analog circuit 114 (Fig. 1) remain isolated from the digital circuit 112 (Fig. 1).

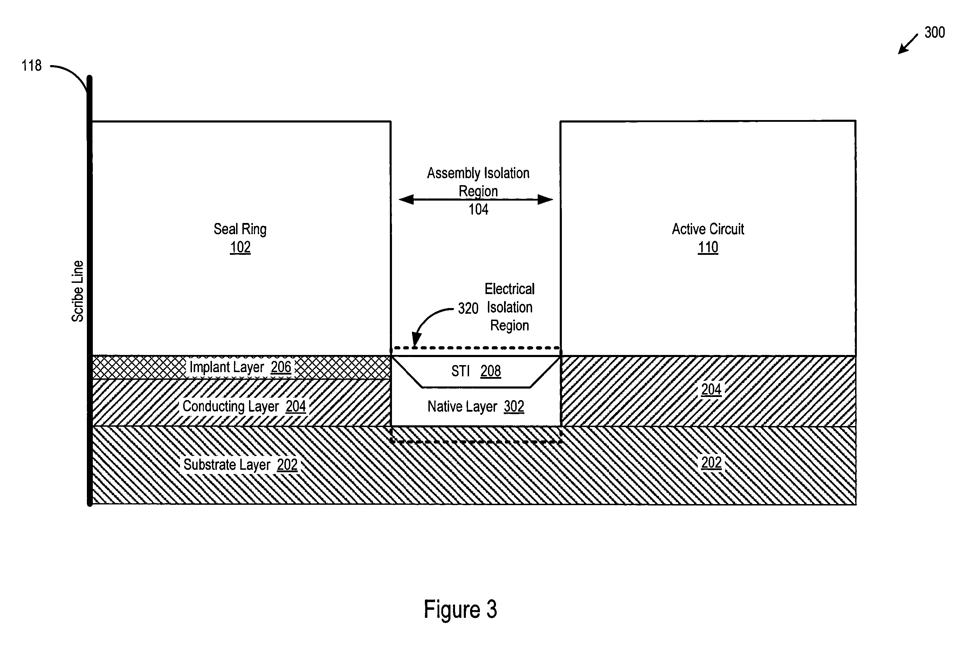

Figure 3 shows another example of a semiconductor die when viewed as cross-section 300. In addition to those elements described above in Figure 2, cross-section 300 shows an electrical isolation region 320. Electrical isolation region 320 may include a native layer 302 that helps improve isolation between active circuit 110 and seal ring 102. The native layer 302 extends to the substrate layer 202 and helps to electrically isolate the seal ring 102 from the active circuit 110. Native layer 302 helps prevent formation of a coupling path 210, as shown in Figure 2. By preventing formation of a coupling path 210 between active circuit 110 and seal ring 102, the signals, noise, and other interference from digital circuit 112 may no longer couple through the seal ring 102 to the analog circuit 114. As a result, the analog circuit 114 may remain isolated from the digital circuit 112.

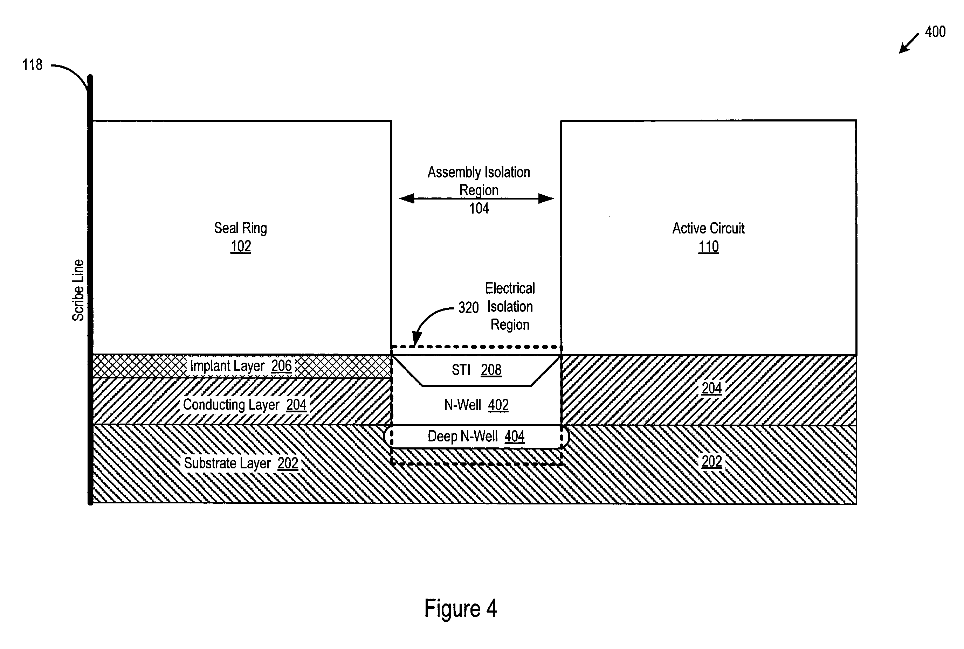

Figure 4 shows another example of a semiconductor die when viewed as a cross-section 400. In addition to those elements described above in Figure 2, cross-section 400 shows an electrical isolation region 320. Electrical isolation region 320 may include an n-well region 402 and a deep n-well region 404. The combination of an n-well region 402 and deep n-well region 404 helps improve isolation between active circuit 110 and seal ring 102. The n-well region 402 and deep n-well region 404 extend into the substrate layer 202 to help electrically isolate the seal ring 102 from the active circuit 110. N-well region 402 and deep n-well region 404 may help increase impedance in the conducting layer 204 between seal ring 102 and active circuit 110 and help prevent formation of a coupling path 210, as shown in Figure 2, through conducting layer 204. By helping to prevent formation of a coupling path between active circuit 110 and seal ring 102, the signals, noise, and other interference from digital circuit 112 may no longer couple through the seal ring 102 to the analog circuit 114. As a result, the analog circuit 114 may remain isolated from the digital circuit 112.

While various embodiments of the invention have been described, it will be apparent that many more embodiments and implementations are possible within the scope of the invention. Accordingly, the invention is not to be restricted.

## Claims

1. A semiconductor structure, comprising:
a substrate layer;
a conductive layer connected with the substrate layer;
an active circuit connected with the conductive layer;
a seal ring connected with the conductive layer and separated from the active circuit by an assembly isolation region; and
an electrical isolation region positioned in the conductive layer and adjacent to the assembly isolation region, where the electrical isolation region extends to the substrate layer.

2. The structure of claim 1, where the active circuit comprises a noise sensitive circuit and a noisy circuit.

3. The structure of claim 2, where the noise sensitive circuit and the noisy circuit comprise a least one of an analog circuit and a digital circuit.

4. The structure of claim 3, further including an active isolation region to electrically isolate the analog circuit from the digital circuit.

5. The structure of claim 1, where the conductive layer comprises a p-well.

6. The structure of claim 1, where the electrical isolation region comprises a shallow trench isolation layer; and a native layer connected with the shallow trench isolation layer and the substrate layer.

7. The semiconductor of claim 6, where the native layer comprises a native oxide which is native to the substrate layer.

8. The structure of claim 1, where the electrical isolation region comprises a shallow trench isolation layer and a well layer connected with the shallow trench isolation layer, where the well layer extends into the substrate.

9. The structure of claim 1 further comprising a well layer and a deep well layer connected with the well layer, where the deep well layer extends into the substrate layer.

10. A semiconductor structure, comprising:
a conductive layer; and
an electrical isolation region positioned in the conductive layer, the electrical isolation region electrically disconnecting the conductive layer between an active circuit and a seal ring.

11. The structure of claim 10 where the electrical isolation region comprises an oxide.

12. The structure of claim 10 where the electrical isolation region comprises a well.

13. The structure of claim 12 where the well comprises an n-well.

14. The structure of claim 10 where the electrical isolation region comprises a well and a deep well.

15. A die, comprising:
a substrate layer;
a conductive layer connected with the substrate layer, the conductive layer including an electrical isolation region;
a seal ring connected with the conductive layer; and
an active circuit connected with the conductive layer, the active circuit electrically separated from the seal ring by the electrical isolation region, where the electrical isolation region connects with the substrate.
